(19)

Europäisches
Patentamt
European
Patent Office
Office européen
des brevets

(11) **EP 2 037 501 A1**

(12) **EUROPEAN PATENT APPLICATION**

(43) Date of publication:
**18.03.2009 Bulletin 2009/12**

(51) Int Cl.:
*H01L 27/02* (2006.01)     *H03K 17/0812* (2006.01)

(21) Application number: **07116428.9**

(22) Date of filing: **14.09.2007**

(84) Designated Contracting States:
**AT BE BG CH CY CZ DE DK EE ES FI FR GB GR
HU IE IS IT LI LT LU LV MC MT NL PL PT RO SE
SI SK TR**
Designated Extension States:
**AL BA HR MK RS**

(71) Applicant: **INTERUNIVERSITAIR
MICROELEKTRONICA CENTRUM VZW
3001 Leuven (BE)**

(72) Inventors:
• **Thijs, Steven
2830 Willebroek (BE)**

• **Tremouilles, David Eric
12260 Villeneuve (FR)**

(74) Representative: **Sarlet, Steven Renaat Irène et al
Gevers & Vander Haeghen SA
Holidaystraat, 5
B-1831 Diegem (BE)**

Remarks:
Amended claims in accordance with Rule 137(2)
EPC.

(54)     **Fast triggering ESD protection device and method for designing same**

(57)     The invention relates to a method for designing an ESD protection circuit comprising a main ESD device and a triggering device connected to a triggering node of the main ESD device by means of which the main ESD device can be triggered for conducting ESD current at a reduced voltage. The triggering device is located in an initial current path for the ESD current. In this initial current path, there is at least one triggering component which can be triggered from an off-state to an on-state. The triggering speed of this component is considered and its design is optimised in view of increasing its triggering speed. The invention further relates to an ESD protection circuit in which at least one triggering component is selected to be of a predetermined type for achieving a fast triggering speed, preferably of the gated diode type.

**FIG. 1**

## Description

### Technical field

This invention generally relates to the field of electrostatic discharge (ESD) protection circuitry and, more specifically, improvements for silicon controlled rectifier (SCR) circuits in the protection circuitry of an integrated circuit (IC).

### Background art

The ongoing advancements in integrated circuit (IC) technologies have led to the use of lower supply voltages to operate the IC's. Designing IC's with lower supply voltages requires the use of very thin gate oxides. The thickness of the gate oxides influences the amount of drive current that is generated. The thinner the gate oxide layer, the more drive current is generated, which thereby increases the speed of the circuit. The gate oxides (e.g., silicon dioxide) may have a thickness of less than 3 nanometers, and further advancements will allow the gate oxide thickness to scale down even further. The lower supply voltages also allow the use of silicon controlled rectifiers (SCRs) with very low holding voltages (e.g., 1.5-2.0V) without introducing a risk of latch-up. The thin gate oxides, which are used in conjunction with low supply voltages, require extreme limitation of transient voltages during an ESD event.

A problem arises using the very thin gate oxides because the oxide breakdown voltage is less than the junction breakdown voltage (e.g., 6-9 volts) that triggers an ESD protection circuit, such as an SCR or NMOS device. As a solution to this problem, in US-B-6,768,616 and Markus P.J. Mergens et al., "Advanced SCR ESD Protection Circuits for CMOS/SOI Nanotechnologies", IEEE 2005 CUSTOM INTEGRATED CIRCUITS CONFERENCE, pp. 481-488, an SCR having an additional current path with trigger diodes is presented. This reduces the trigger voltage of the SCR, but apparently the voltage overshoot appearing on the IC which is supposed to be protected is still too large, leading to breakdown of the gate oxide.

### Disclosure of the invention

It is an aim of the present invention to provide an ESD protection device and method for designing same with which the overshoot appearing over the IC can be further reduced.

This aim is achieved according to the invention with the method and device of the independent claims.

According to the invention, a method is presented for designing an ESD protection circuit for protecting an integrated circuit connected between a first node and a second node against an ESD event. As a first step, a main ESD device is inserted between said first and second nodes. The main ESD device comprises at least a first component which forms a triggering node of the device. By means of this triggering node, the main ESD device can be triggered for conducting ESD current from the first node to the second node. As a subsequent design step, a triggering device is connected between the triggering node of the main ESD device and one or both of the first and second nodes. The purpose of this triggering device is to trigger the main ESD device upon occurrence of an ESD event at a reduced triggering voltage, reduced with respect to the triggering voltage the main ESD device would have without the triggering device. This triggering device forms part of an initial current path which initially conducts the ESD current. In this initial current path there is at least one triggering component which can be triggered from an off-state to an on-state. Examples of such triggering components are triggering diodes of the triggering device or a transistor junction within the main ESD device.

An analysis of the prior art has shown that the problem of the overshoot still appearing over the IC is caused by too slow triggering of the ESD device. The addition of the triggering diodes reduces the triggering voltage of the ESD device, which has a positive impact on the triggering speed in that the device turns on at a lower voltage which is reached sooner, but the time needed for making the transition from "off" to "on" once the triggering voltage is reached is not considered.

According to the invention, an additional design step is introduced, namely to consider the components in the initial current path and to optimise their design in view of the triggering speed, i.e. the time the respective component needs for turning from the off-state to the on-state, once the trigger voltage is reached. This optimisation is possible in view of newly developed techniques, which will be described herein, by means of which the transient response and hence the triggering speed of a device or component can be accurately determined.

At least one of the components in the initial current path is optimised in view of triggering speed. This optimisation can be both in the structure and in the layout of the components. Preferably, all components in this path are optimised, including any diodes or junctions of the main ESD device which may be in this initial current path, for example a bipolar transistor whose base-emitter junction forms a diode within the initial current path and whose base forms the triggering node of the main ESD device.

In preferred embodiments of the invention, the optimisation step comprises determining the triggering speed of a number of different types of diodes and selecting the type which triggers fastest for preferably all of the triggering components. With different types is meant having a different structure, for example gated diodes vs. STI diodes.

In preferred embodiments of the invention, gated diodes (also known as poly diodes) are selected as the diode type for preferably all of the triggering components.

In preferred embodiments of the invention, the triggering device comprises a plurality of triggering components, the number of triggering components being determined as a trade-off between the triggering voltage of the main ESD device and a leakage current conducted along the initial current path during normal operation of the integrated circuit.

In preferred embodiments of the invention, the main ESD device is a silicon controlled rectifier. However, the invention is also applicable to other types of ESD devices.

## Brief description of the drawings

The invention will be further elucidated by means of the following description and the appended figures.

Figure 1 schematically shows a general representation of a first embodiment of the invention.

Figure 2 schematically shows a general representation of a second embodiment of the invention.

Figure 3 schematically shows a general representation of a third embodiment of the invention.

Figure 4 schematically shows a general representation of a fourth embodiment of the invention.

Figure 5 schematically shows more specific embodiments according to the invention, in which the main ESD device is each time formed by a silicon controlled rectifier SCR.

Figure 6 shows another more specific embodiment of a circuit according to the invention, comprising an SCR as main ESD device.

Figure 7 shows a cross-section of a practical implementation of an SCR.

Figure 8 shows a top view of a circuit implementation in accordance with the scheme of figure 6, the triggering diodes being located on the side of the SCR.

Figure 9 shows a top view of another circuit implementation in accordance with the scheme of figure 6, the triggering diodes being located on top of the SCR.

Figure 10 shows the measurement setup which is used to determine the transient response of the circuit of figure 6 and to optimize the design of the triggering components, by applying a 4 kV HBM (human body model) pulse.

Figure 11 shows the results of using the HBM measurement setup of figure 10 to apply a 4 kV HBM pulse to the circuit of figure 6, type A (HBM_raw - uncorrected data, HBM_corr - corrected data, HBM_corr_filt - corrected and filtered data).

Figure 12 shows an overlay of the fully corrected and filtered HBM IV curve with the TLP IV curve obtained from the same device type A.

Figure 13 shows HBM IV curves obtained from the different devices type A, B and C with a HBM stress level of 500 V HBM.

Figure 14 shows an overlay of HBM voltage waveforms obtained from the different device types A, B and C with a focus on the rising (overshoot) part, at HBM stress level 500V.

Figure 15 shows an overlay of HBM IV curves obtained from a poly and a STI diode of the same width and spacing between n+ and p+ active, at HBM stress level 1000V.

Figure 16 shows a correlation between $I_{t2}$ obtained from TLP testing and overshoot peak voltages obtained from 500 V HBM stress for the different device types A, B and C.

Figure 17 shows a cross-section of a poly diode.

Figure 18 shows a cross-section of an STI diode.

## Modes for carrying out the invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the invention described herein can operate in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

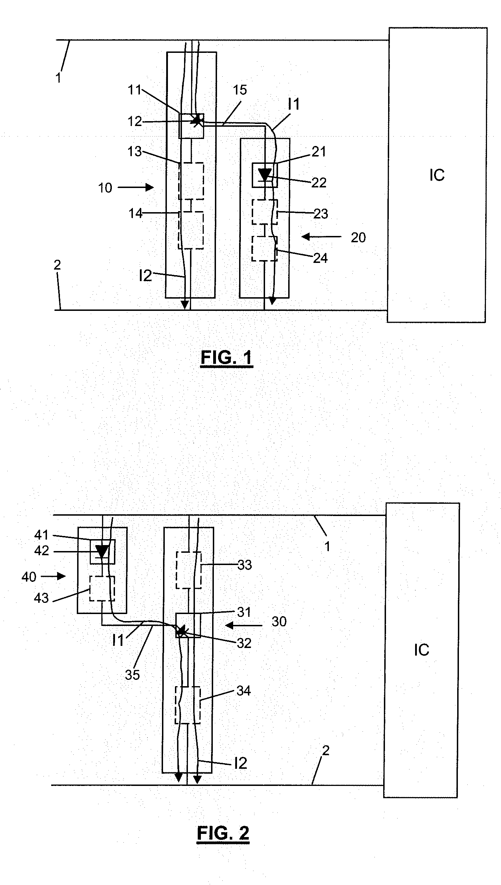

A first embodiment of an ESD protection circuit according to the invention is shown in figure 1. The circuit is designed for protecting an integrated circuit "IC" connected between a first node 1 and a second node 2 against an ESD event. The circuit comprises a main ESD device 10 and a triggering device 20. The main ESD device 10 is connected between the first and second nodes 1, 2 and is arranged for being triggered upon an ESD event and subsequently conducting ESD current from the first node 1 to the second node 2. This current is represented as the arrow I2. The main ESD device comprises a first component 11 with a first diode 12 and possibly other components 13, 14 in the current path I2. The first component 11 forms a triggering node 15 of the main ESD device 10 by means of which the device can be triggered for conducting the current I2. The triggering device 20 is connected between the triggering node 15 of the main ESD device 10 and the second node 2 and is added to reduce the triggering voltage of the main ESD device 10. This triggering device 20 comprises a triggering component 21 comprising a second diode 22 and possibly a number of other components 23, 24. The diodes 12, 22 are biased in the same direction. Together, the first and second diodes 12, 22 form part of an initial current path via which the ESD current initially flows, represented as the arrow I1.

A second embodiment of an ESD protection circuit according to the invention is shown in figure 2. The circuit comprises a main ESD device 30 and a triggering device 40. The main ESD device 30 is connected between the first and second nodes 1, 2 and is arranged for being triggered upon an ESD event and subsequently conducting ESD current from the first node 1 to the second node 2. This current is represented as the arrow I2. The main ESD device comprises a first component 31 with a first diode 32 and possibly other components 33, 34 in the current path I2. The first component 31 forms a triggering node 35 of the main ESD device 30 by means of which the device can be triggered for conducting the current I2. The triggering device 40 is connected between the triggering node 35 of the main ESD device 30 and the second node 2 and is added to reduce the triggering voltage of the main ESD device 30. This triggering device 40 comprises a triggering component 41 comprising a second diode 42 and possibly a number of other components 43. The diodes 32, 42 are biased in the same direction. Together, the first and second diodes 32, 42 form part of an initial current path via which the ESD current initially flows, represented as the arrow I1.

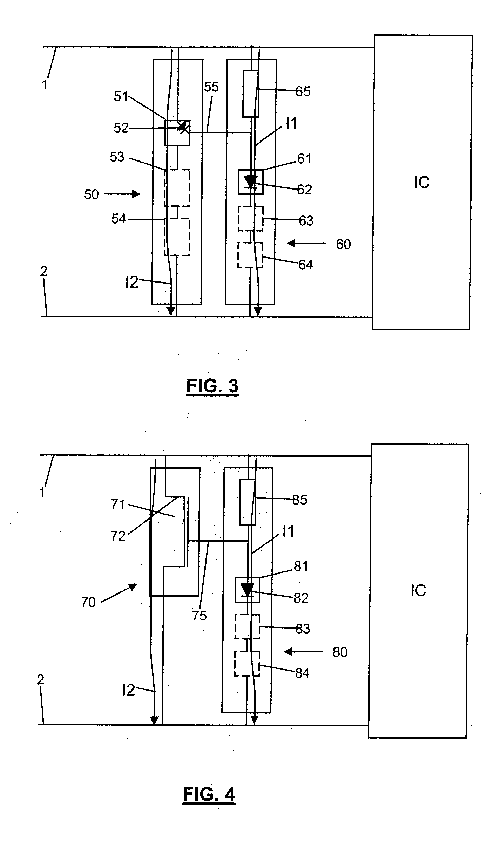

A third embodiment of an ESD protection circuit according to the invention is shown in figure 3. The circuit comprises a main ESD device 50 and a triggering device 60. The main ESD device 50 is connected between the first and second nodes 1, 2 and is arranged for being triggered upon an ESD event and subsequently conducting ESD current from the first node 1 to the second node 2. This current is represented as the arrow I2. The main ESD device comprises a first component 51 with a first diode 52 and possibly other components 53, 54 in the current path I2. The first component 51 forms a triggering node 55 of the main ESD device 50 by means of which the device can be triggered for conducting the current I2. The triggering device 60 is connected between the triggering node 55 of the main ESD device 50, the first node 1 and the second node 2. It is added to reduce the triggering voltage of the main ESD device 50. Downstream from the triggering node 55, i.e. between this node and the second node 2, the triggering device 60 comprises a triggering component 61 comprising a second diode 62 and possibly a number of other components 63, 64. The diodes 52, 62 are biased in the same direction. Here, the triggering device 60 further comprises a resistor 65 between the triggering node 55 and the first node 1 to form an initial current path I1 which does not flow through the main ESD device 50. As the initial current I1 starts to flow, a voltage is built up over the resistor 65 which triggers the main ESD device 50 as soon as the voltage is above the threshold for the triggering node 55.

A fourth embodiment of an ESD protection circuit according to the invention is shown in figure 4. The circuit comprises a main ESD device 70 and a triggering device 80. The main ESD device 70 is connected between the first and second nodes 1, 2 and is arranged for being triggered upon an ESD event and subsequently conducting ESD current from the first node 1 to the second node 2. This current is represented as the arrow I2. Here, the main ESD device comprises a single component, more particularly a transistor 71, whose base-emitter junction forms a first diode 72 and whose base forms a triggering node 75 by means of which the transistor 71 can be triggered for conducting the current I2. The triggering device 80 is connected between the triggering node 75, the first node 1 and the second node 2. Downstream from the triggering node 75, i.e. between this node and the second node 2, the triggering device 80 comprises a triggering component 81 comprising a second diode 82 and possibly a number of other components 83, 84. The diodes 72, 82 are biased in the same direction. Here again, the triggering device 80 further comprises a resistor 85 between the triggering node 75 and the first node 1 to form an initial current path I1. As the initial current I1 starts to flow, a voltage is built up over the resistor 85 which triggers the transistor 71 as soon as the voltage is above the threshold.

In figures 1-4, optional components are shown in dashed lines. However, each of these embodiments can comprise also other optional components at other locations.

For all embodiments of figures 1-4, in order to reduce the overshoot appearing over the IC the triggering components 12, 32, 21, 41, 61, 81 in the current path I1 are designed in view of keeping the triggering time, i.e. the time needed to go from the "off" state to the "on" state once the necessary triggering voltage is reached, as short as possible. This optimisation is possible in view of newly developed techniques, which will be described below, by means of which the transient response and hence the triggering speed of a device or component can be accurately determined.

At least one of the triggering components 21, 41, 61, 81 in the initial current path I1 is optimised in view of triggering speed. Preferably, all triggering components in this path are optimised, including the first diode 12, 32, which is part of the first component 11, 31 of the main ESD device 10, 30 and is in the initial current path in the embodiments of figures 1 and 2. This first component 11, 31 is for example a bipolar transistor whose base-emitter junction forms the first diode 12, 32.

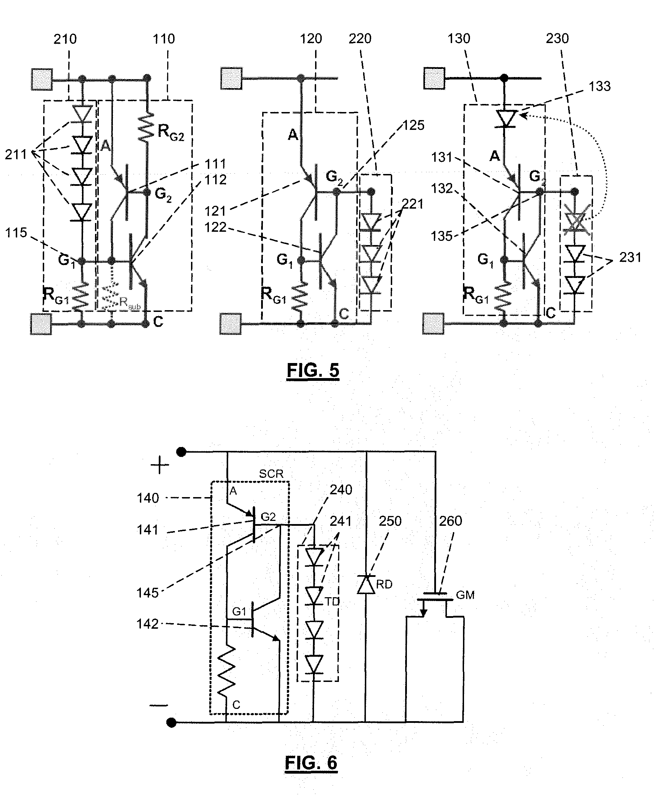

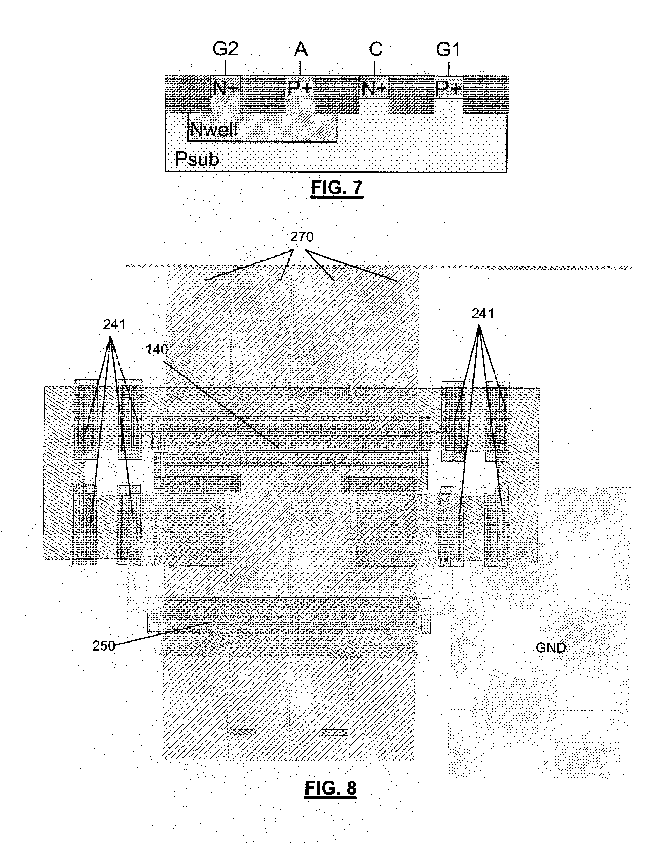

Figure 5 shows more specific embodiments according to the invention, in which the main ESD device is each time formed by a silicon controlled rectifier SCR 110, 120, 130. The SCR protection device is illustratively represented as an NPN transistor 111, 121, 131 and a PNP transistor 112, 122, 132 as is well known in the art, see figure 7 for a cross-section of a practical implementation of an SCR. "A" refers to the anode of the SCR, coupled to the first node 1. "C" refers to the cathode of the SCR, coupled to the second node 2. Various parasitic resistances "R" are also shown. In the embodiment on the left in figure 5, the gate G1 of the PNP transistor 112 forms the triggering node 115 to which the triggering device 210 is connected. The triggering device 210 comprises four triggering diodes 211, which according to the invention are predeterminedly selected to be of a type whose triggering time is short, for example the gated diode type. The initial current path flows through the gate resistance RG1, so that four triggering diodes 211 are selected in view of minimising current leakage during normal operation of the protected IC. In the embodiment on the middle, the gate G2 of the NPN transistor 121 forms the triggering node 125, to which the triggering device 220 is connected. Here, the initial current path is formed by the base-emitter junction of the NPN transistor 121 and the (preferably gated) triggering diodes 221 of the triggering device 220. In order to minimise leakage current during normal operation of the protected IC, three triggering diodes 221 are sufficient here since the base-emitter junction forms a fourth diode in the leakage current path. This base-emitter junction is preferably also designed as a gated diode. In the embodiment on the right, also the gate G2 of the NPN transistor 131 forms the triggering node 135. Here, one of the (preferably gated) diodes 231 of the triggering device 230 is moved to the main ESD device 130, upstream of the SCR 131-132. This increases the hold voltage of the ESD device 130 while the trigger voltage and the leakage current remains the same. In general, the number n of diodes in the initial current path is chosen as trade-off between low leakage during normal operation ("maximize n") and low ESD trigger voltage ("minimize n").

Figure 6 shows another more specific embodiment of a circuit according to the invention, again comprising an SCR 140 with NPN and PNP transistors 141-142 as main ESD device. Again the gate G2 of the NPN transistor 141 forms the triggering node 145 to which the triggering device 240 is connected. Here, the triggering device 240 comprises four triggering diodes TD 241 to ensure low leakage during normal operation at bias conditions of 1.8V. A reverse diode RD 250 is provided for ESD protection purposes in the opposite direction. A gate monitor GM 260 is placed in parallel. The triggering diodes 241, preferably along with the base-emitter (or Anode-G2) junction of the NPN transistor 141 are designed to trigger fast in view of reducing the triggering time of the initial current path upon occurrence of an ESD event. Preferably, this is done by selected the gated diode type for these diodes 241. In the case of the Anode-G2 junction of the transistor 141, this is done by using a gate to isolate the gate G2 from the Anode.

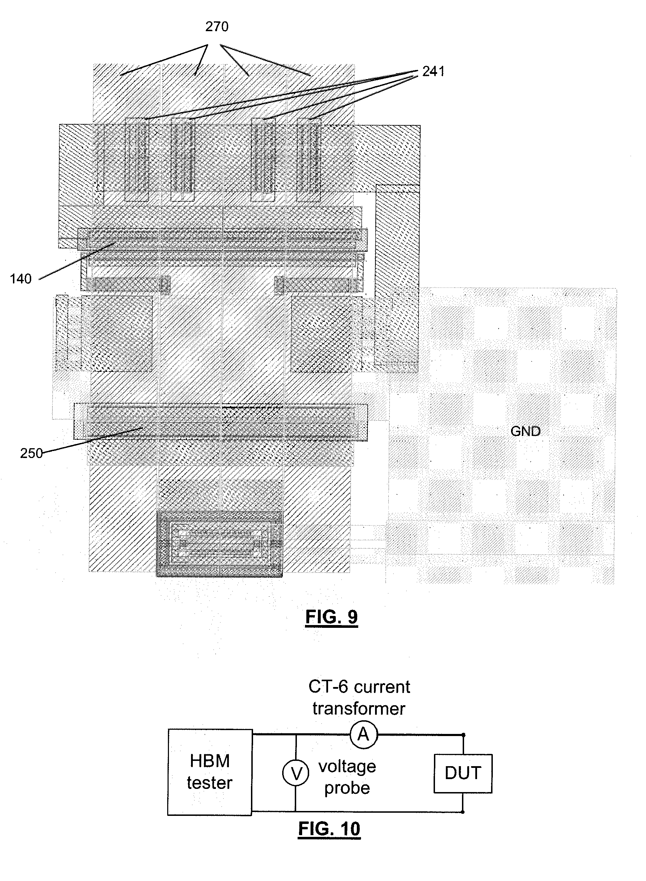

Using gated diodes 241 to trigger the SCR 140 has further advantages. These diodes do not have to be very large and can be placed on the side of the device as shown in figure 8, which shows a top view of an implementation in accordance with figure 6. No large area is used up by the diodes 241, so the metal I/O lines can be larger which makes the connections easier and reduces capacitance. The TD 241 can also be placed above the SCR 140, leading to a more compact layout as shown in figure 9. Furthermore, because the use of gated diodes as triggering diodes 241 reduces the overshoot, an additional triggering diode could be placed to reduce the leakage. The I/O lines 270 and the ground lines GND correspond to the first and second nodes 1, 2 of figures 1-4.

Below, the circuit of figure 6 is used for the purposes of explaining the invention in detail, but it should be noted that the invention is applicable to other circuits as well.

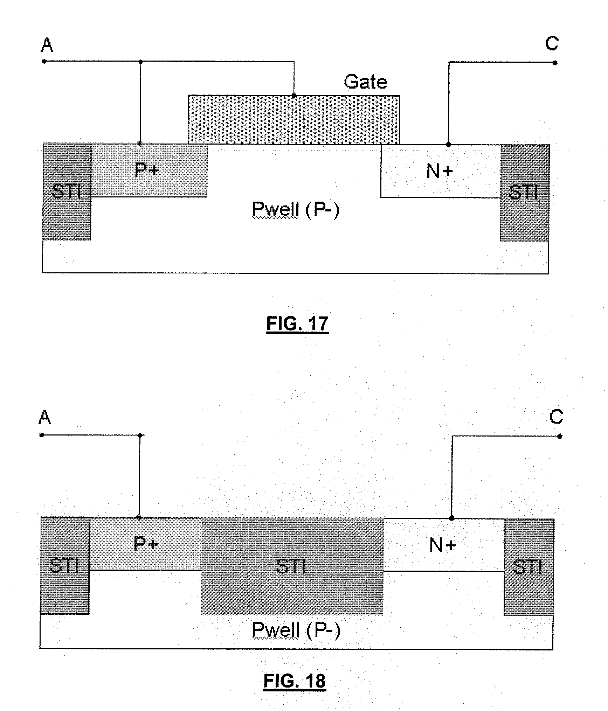

Three different circuit variations A, B and C are used for explaining the invention. Type A is the reference circuit with small trigger diodes TD and a small Anode-G2 junction inside the SCR. Type B is a speed-optimized version of Type A, where both the trigger diodes and the Anode-G2 junction are made equally wide as the SCR body. A further proposed speed improvement is provided by Type C. The same sizes are kept as in Type B but both the Anode-G2 junction and the trigger diodes are changed from shallow-trench-isolated (STI)-defined (shown in figure 18) to poly-defined or gated (shown in figure 17). This is summarised in table 1.

**Table 1:** Summary of the compared device types

|  | Type A | Type B | Type C |
|---|---|---|---|
| **Device** | SCRz_ref | SCR_all_STI | SCR_all_poly |

TLP (transmission line pulsing) measurements are performed on all three SCR types. They yield similar results (Table 2).

**Table 2:** TLP-IV parameters for the three types of SCR: $V_H$ - holding voltage, $V_{t1}$ - triggering voltage, $R_{ON}$ - on-resistance, $I_{t2}$ - TLP failure level

|  | Type A | Type B | Type C |
|---|---|---|---|
| $V_H$ **(V)** | 1 | 1 | 1 |
| $V_{t1}$ **(V)** | 4.2 | 3.8 | 3.8 |
| $R_{on}$ **($\Omega$)** | 1.1 | 1.1 | 1.2 |
| $I_{t2}$ **(A)** | 1.9 | 1.9 | 1.9 |

When measuring these three types of SCR devices in a configuration with a gate monitor GM in parallel, the acquired results are varying. $I_{t2}$ is much lower than expected, indicating a voltage overshoot during the TLP pulse that damages the gate oxide of the monitor (Table 3). These voltage overshoots are limiting the ESD robustness of the device types A and B. For device type C no failure due to oxide breakdown was observed. It fails due to SCR failure and hence it yields the same robustness as without gate monitor.

**Table 3:** TLP and HBM failure levels for the three types of SCR devices with a gate monitor in parallel

|  | Type A | Type B | Type C |
|---|---|---|---|
| **Device** | SCR_ref | SCR_all_STI | SCR_all_poly |
| $I_{t2}$ **(A)** | 0.7 | 1.45 | 1.9 |
| **HBM (kV)** | 0.5 | 2.6 | 4.6 |

To demonstrate the methodology of optimizing the design of the triggering components, a 4 kV HBM (human body model) pulse is applied to a type A SCR device without gate monitor, using recently developed techniques, which will first be explained in general. Figure 10 shows the measurement setup. A commercial wafer-level HBM tester (Hanwa HED-W5000M) is used which creates HBM pulses according to the ESDA standard. By adding certain features, it is able to simultaneously capture voltage and current over time at a device under test (DUT) during HBM stress. This allows generating an HBM IV curve. Voltage over time is captured by a commercial voltage probe (Tektronix) with 500MHz bandwidth and an input capacitance of 8nF. This probe type represents a good compromise between required bandwidth and the maximum voltage which can be measured without degrading the probe. Usually voltage probes with a higher bandwidth are not able to withstand the high voltages which occur at a device under HBM stress. The Tektronix CT-6 current transformer is also chosen due to its form factor which allows direct mounting on the probe needle. The frequency response of the current transformer is from 250kHz to 2GHz. The limitation for low frequencies distorts the measurement of HBM current waveforms and results in showing negative current values. Studies also show that parasitic elements in the measurement setup, like the inductance ($L_p$) and resistance ($R_p$) of the probe needles, are influencing the voltage waveform measurements. To remove the low frequency distortion of the current transformer, the transfer function TF of the current transformer is determined for the calculation of the real current $I_{corr}$ out of the measured current $I_{CT}$ (1).

$$I_{corr} = TF \cdot I_{CT}$$

$$(1)$$

This corresponds to a de-convolution problem, where the determination of an unknown input signal is calculated from the measured output signal if the transfer function TF of the system is known.

The calibration methodology described in the following allows to extract the transfer function TF and the needle parasitic resistance $R_p$ and inductance $L_p$. They are calculated from HBM voltage waveforms $V_{cl}$ and current waveforms $I_{ct}$ captured on a known resistive load $R_L$ and on a short.

Measured voltage $V_{cl}$ and current $I_{CT}$ are aligned in time and transformed to the frequency domain. Two expressions of the transfer function of the current transformer are obtained - one for the load $R_L$ (2) and one for the short (3) measurement.

$$TF_{cl}^{load} = \frac{I_{corr}^{load}(\omega)}{I_{CT}^{load}(\omega)} = \frac{V_{cl}^{load}(\omega)}{(R_L + Z_p) \cdot I_{CT}^{load}(\omega)} \tag{2}$$

$$TF_{cl}^{short} = \frac{I_{corr}^{short}(\omega)}{I_{CT}^{short}(\omega)} = \frac{V_{cl}^{short}(\omega)}{Z_p \cdot I_{CT}^{short}(\omega)} \tag{3}$$

$$Z_p = 2 \cdot \left( R_p + j\omega L_p \right) \tag{4}$$

where $Z_P$ is the impedance of the needles. Both transfer functions are identical as they are obtained with the same current transformer and on the same setup:

$$\frac{V_{cl}^{short}(\omega)}{Z_p \cdot I_{CT}^{short}(\omega)} = \frac{V_{cl}^{load}(\omega)}{(R_L + Z_p) \cdot I_{CT}^{load}(\omega)} = TF \tag{5}$$

From (5) $Z_p$ is obtained as

$$Z_p = \frac{V_{cl}^{short}(\omega) \cdot R_L \cdot I_{CT}^{load}(\omega)}{V_{cl}^{load}(\omega) \cdot I_{CT}^{short}(\omega) - V_{CL}^{short}(\omega) \cdot I_{CT}^{load}(\omega)} \tag{6}$$

For the used measurement setup a series resistance $R_p$ of $0.8\Omega$ and an inductance $L_p$ of 15nH are extracted for a single needle. Finally, TF is obtained by substituting (6) in (2) or (3).

To obtain the real current through the device under test (DUT), the measured current waveform $I_{meas}^{DUT}$ is transformed to the frequency domain and multiplied with the transfer function TF (7)

$$I_{corr}^{DUT}(\omega) = TF \cdot I_{meas}^{DUT}(\omega) \tag{7}$$

A corrected voltage waveform across the DUT is calculated referring to equation (8).

$$V_{corr}^{DUT}(\omega) = V_{meas}^{DUT}(\omega) - Z_p \cdot I_{corr}^{DUT}(\omega) \tag{8}$$

Due to limited power of the signal spectrum at high frequencies, the numerator and denominator in equation (2) and (3) become very small. The result is unrealistic values at high frequencies that have to be removed before the IFFT operation. Therefore, the introduction of an additional filter is required and a minimum phase filter (Bennia-Nahman) was chosen. The corrected current $I^{DUT}_{corr}(\omega)$ and voltage $V^{DUT}_{corr}(\omega)$ waveforms are transformed to the time domain. Finally, after alignment in time, current in time is plotted over voltage in time obtained from the same device. The resulting IV curve shows the IV characteristic of the device under test during an HBM stress.

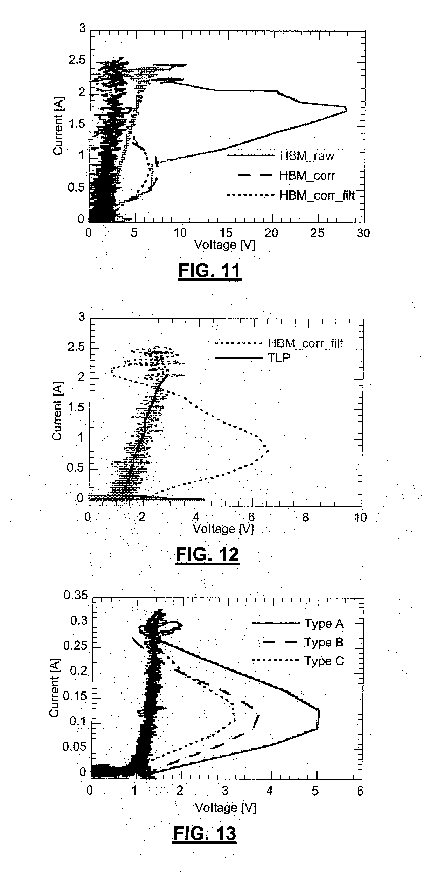

Using the HBM measurement setup of figure 10 to apply a 4 kV HBM pulse to the circuit of figure 6, type A, yields the results shown in figure 11 (HBM_raw - uncorrected data, HBM_corr - corrected data, HBM_corr_filt - corrected and filtered data). The influence of the system parasitic can be clearly seen. Without correction of measurement data the voltage overshoot is much higher (28V peak) than the one after correction (7V peak). Also the linear part of the HBM IV curve is different. The slope (or on-resistance) is lower after applying the above-described calibration methodology to the measurement data. The filtering removes the noise from the linear part of a HBM IV curve but also reduces slightly the overshoot voltage.

An overlay of the fully corrected and filtered HBM IV curve with the TLP IV curve obtained from the same device type A shows good correlation (Figure 12). Holding voltage and on-resistance are identical for HBM and TLP. Depending on the type of SCR $I_{t2}$ is lower for the configuration with a gate monitor in parallel. Therefore HBM pulses with corresponding HBM stress level below the lowest $I_{t2}$ value are used to compare the HBM IV of the different device types A, B and C.

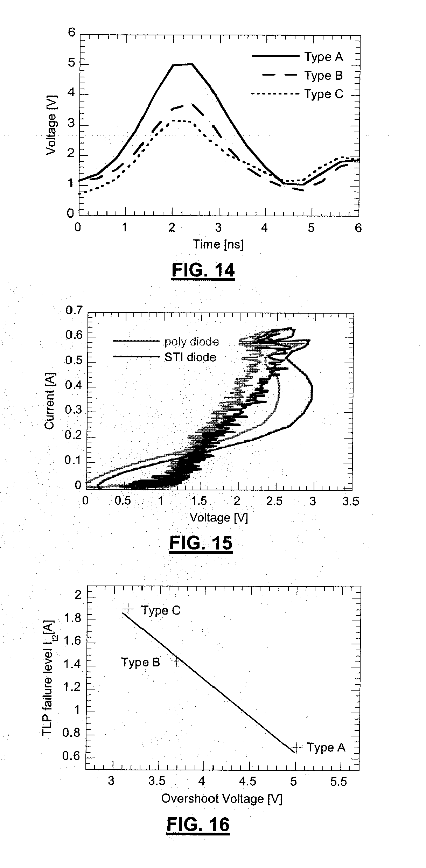

Figure 13 and Figure 14 demonstrate that the different types A, B and C show a different transient behavior for the same HBM pulse amplitude. Figure 13 shows HBM IV curves obtained from the different devices with a HBM stress level of 500 V HBM. Figure 14 shows an overlay of HBM voltage waveforms obtained from the different device types A, B and C with a focus on the rising (overshoot) part, at HBM stress level 500V. The results show that device type A is the slowest device and builds up the highest overshoot voltage during the rising of the HBM pulse. Device type B triggers faster than type A and therefore builds up less overshoot. The highest improvement can be obtained by using poly instead of STI for the trigger diodes and inside of the SCR. Device type C builds up the lowest overshoot which corresponds to the highest trigger speed (i.e. shortest trigger time) in comparison to type A and B. This leads to an increased HBM robustness when stressing the configuration with gate monitor in parallel (Table 3). Due to the improvements type C fails at a HBM stress level of 4.6kV whereas type B fails at 2.6kV.

Comparing the transient behavior of the poly/gated and STI diodes gives more understanding of the different transient behavior of the circuit of figure 6 type A, B and C. Figure 15 shows an overlay of HBM IV curves obtained from a poly and a STI diode of the same width and spacing between n+ and p+ active, at HBM stress level 1000V. This figure shows the transient behavior of an STI diode and a poly diode during the same HBM stress. The overshoot voltage of the STI diode is higher which is due to a slower device triggering. This is explained from a comparison of the structure of the two, see figures 17 and 18. In poly diodes (Fig. 17) the current can flow horizontal and does not have to flow below the STI which isolates Anode from Cathode in the case of STI diodes (Fig. 18). As a result, the base length is lower and the triggering occurs faster. Poly diodes can be designed even faster because of the lower allowed spacing between n+ and p+ active in comparison to STI diodes. Additionally the on-resistance of the poly diode is lower. It is remarked that both in figures 17 and 18, the Pwell can be substituted by Nwell if multiple diodes are to be placed in series.

These results can be used to explain the different TLP failure level $I_{t2}$ of the device types A, B and C with a gate monitor in parallel. Overshoot voltages occurring during the HBM stress cause the failure of the gate monitor. Therefore in respect to the peak value of the overshoot voltages a clear correlation is found to $I_{t2}$ obtained during TLP stress, as illustrated by Figure 16 which shows a correlation between $I_{t2}$ obtained from TLP testing and overshoot peak voltages obtained from 500 V HBM stress for the different device types. Slow device triggering and the resulting high overshoot voltage are directly corresponding to a low TLP failure level $I_{t2}$.

**Claims**

1. Method for designing an ESD protection circuit for protecting an integrated circuit connected between a first node and a second node against an ESD event, comprising the steps of:

    a) inserting a main ESD device between said first and second nodes, said main ESD device comprising at least a first component forming a triggering node by means of which the main ESD device can be triggered for conducting ESD current from said first node to said second node,

    b) connecting a triggering device to said triggering node and at least one of the first and second nodes, said triggering device forming part of an initial current path for initially conducting current from the first node to the second node upon occurrence of an ESD event and thereby triggering the main ESD device at a reduced triggering voltage, said initial current path comprising at least one triggering component which can be triggered from an off-state to an on-state,

**characterised in that** the method further comprises the step of:

c) considering the triggering speed of the at least one triggering component and optimising its design in view of increasing its triggering speed.

2.  Method according to claim 1, **characterised in that** at least one of the triggering components comprises a diode and **in that** step c) comprises determining the triggering speed of a number of different diode types and selecting for said diode the diode type which triggers fastest.

3.  Method according to claim 2, **characterised in that** step c) comprises selecting a gated diode type for said diode.

4.  Method according to claim 1, 2 or 3, **characterised in that** the triggering device comprises a plurality of triggering components, the method further comprising determining the number of triggering components as a trade-off between the triggering voltage and a leakage current conducted along the initial current path during normal operation of the integrated circuit.

5.  Method according to any one of the previous claims, **characterised in that** said first component is a bipolar transistor whose base-emitter junction forms one of the triggering components in the initial current path.

6.  ESD protection circuit for protecting an integrated circuit connected between a first node and a second node against an ESD event, comprising:

    - a main ESD device connected between said first and second nodes, said main ESD device comprising at least a first component forming a triggering node by means of which the main ESD device can be triggered for conducting ESD current from said first node to said second node,
    - a triggering device connected between said triggering node and at least one of said first and second nodes, said triggering device forming part of an initial current path for initially conducting current from the first node to the second node upon occurrence of an ESD event and thereby triggering the main ESD device at a reduced triggering voltage, said initial current path comprising at least one triggering component which can be triggered from an off-state to an on-state,

    **characterised in that** at least one of the triggering components is of a predetermined type, selected for increasing the triggering speed of said initial current path.

7.  ESD protection circuit according to claim 6, **characterised in that** at least one of the triggering components is a gated diode.

8.  ESD protection circuit according to claim 6 or 7, **characterised in that** the triggering device comprises a predetermined number of triggering components, said predetermined number being determined as a trade-off between the triggering voltage and a leakage current conducted along the initial current path during normal operation of the integrated circuit.

9.  ESD protection circuit according to claim 6, 7 or 8, **characterised in that** said first component is a bipolar transistor whose base-emitter junction forms one of the triggering components.

10. ESD protection circuit according to claim 9, **characterised in that** said main ESD device is a silicon controlled rectifier.

11. ESD protection circuit according to claim 10, **characterised in that** said triggering components are implemented on the side of said silicon controlled rectifier.

12. ESD protection circuit according to claim 10, **characterised in that** said triggering components are implemented on top of said silicon controlled rectifier.


**Amended claims in accordance with Rule 137(2) EPC.**

1.  Method for designing an ESD protection circuit for protecting an integrated circuit connected between a first node and a second node against an ESD event, comprising the steps of:

a) inserting a main ESD device between said first and second nodes, said main ESD device comprising at least a first component forming a triggering node by means of which the main ESD device can be triggered for conducting ESD current from said first node to said second node,

b) connecting a triggering device to said triggering node and at least one of the first and second nodes, said triggering device forming part of an initial current path for initially conducting current from the first node to the second node upon occurrence of an ESD event and thereby triggering the main ESD device at a reduced triggering voltage, said initial current path comprising at least one triggering component which is adapted for triggering from an off-state to an on-state at a predetermined triggering voltage,

**characterised in that** the method further comprises the step of:

c) considering for each of the at least one triggering component the time which it needs for making the transition from said off-state to said on-state once its predetermined triggering voltage is reached and optimising its design in view of reducing said transition time.

2. Method according to claim 1, **characterised in that** at least one of the triggering components comprises a diode and **in that** step c) comprises determining the transition time of a number of different diode types and selecting for said diode the diode type which triggers fastest.

3. Method according to claim 2, **characterised in that** step c) comprises selecting a gated diode type for said diode.

4. Method according to claim 1, 2 or 3, **characterised in that** the triggering device comprises a plurality of triggering components, the method further comprising determining the number of triggering components as a trade-off between the triggering voltage and a leakage current conducted along the initial current path during normal operation of the integrated circuit.

5. Method according to any one of the previous claims,
**characterised in that** said first component is a bipolar transistor whose base-emitter junction forms one of the triggering components in the initial current path.

6. ESD protection circuit for protecting an integrated circuit connected between a first node and a second node against an ESD event, comprising:

- a main ESD device connected between said first and second nodes, said main ESD device comprising at least a first component forming a triggering node by means of which the main ESD device can be triggered for conducting ESD current from said first node to said second node,

- a triggering device connected between said triggering node and at least one of said first and second nodes, said triggering device forming part of an initial current path for initially conducting current from the first node to the second node upon occurrence of an ESD event and thereby triggering the main ESD device at a reduced triggering voltage, said initial current path comprising at least one triggering component which is adapted for triggering from an off-state to an on-state at a predetermined triggering voltage,

**characterised in that** at least one of the triggering components is of a predetermined type, selected on the basis of the time which it needs for making the transition from said off-state to said on-state once its predetermined triggering voltage is reached, such that the triggering speed of said initial current path is increased.

7. ESD protection circuit according to claim 6, **characterised in that** at least one of the triggering components is a gated diode.

8. ESD protection circuit according to claim 6 or 7, **characterised in that** the triggering device comprises a predetermined number of triggering components, said predetermined number being determined as a trade-off between the triggering voltage and a leakage current conducted along the initial current path during normal operation of the integrated circuit.

9. ESD protection circuit according to claim 6, 7 or 8, **characterised in that** said first component is a bipolar transistor whose base-emitter junction forms one of the triggering components.

10. ESD protection circuit according to claim 9, **characterised in that** said main ESD device is a silicon controlled rectifier.

11. ESD protection circuit according to claim 10, **characterised in that** said triggering components are implemented on the side of said silicon controlled rectifier.

12. ESD protection circuit according to claim 10, **characterised in that** said triggering components are implemented on top of said silicon controlled rectifier.

FIG. 1

FIG. 2

**FIG. 3**

**FIG. 4**

**FIG. 5**

**FIG. 6**

G2     A     C     G1

N+    P+    N+    P+

Nwell

Psub

**FIG. 7**

270

241         241

140

250

GND

**FIG. 8**

270

241

140

250

GND

**FIG. 9**

CT-6 current
transformer

HBM
tester

(A)

(V) voltage
probe

DUT

**FIG. 10**

**FIG. 11**

**FIG. 12**

**FIG. 13**

**FIG. 14**

**FIG. 15**

**FIG. 16**

A                                                    C

Gate

STI    P+                    N+    STI

Pwell (P-)

**FIG. 17**

A                                                    C

STI    P+          STI          N+    STI

Pwell (P-)

**FIG. 18**

**European Patent Office**

**EUROPEAN SEARCH REPORT**

Application Number

EP 07 11 6428

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 02/075891 A (SARNOFF CORP [US]; SARNOFF EUROP [BE]) 26 September 2002 (2002-09-26) * figure 3 * | 1-12 | INV. H01L27/02 H03K17/0812 |
| X | US 2006/262471 A1 (VAN CAMP BENJAMIN [BE]) 23 November 2006 (2006-11-23) * figures 1,2A * | 1-12 | |
| X | US 6 777 721 B1 (HUANG CHENG [US] ET AL) 17 August 2004 (2004-08-17) * figure 2E * | 1-12 | |
| X | WO 96/05641 A (SARNOFF DAVID RES CENTER [US]) 22 February 1996 (1996-02-22) * figure 3 * | 1-12 | |
| X | US 2007/120193 A1 (INOUE TOMOKI [JP]) 31 May 2007 (2007-05-31) * figures 12,13 * | 1-12 | |
| | | | TECHNICAL FIELDS SEARCHED (IPC) |
| | | | H01L H03K |

The present search report has been drawn up for all claims

| Place of search | Date of completion of the search | Examiner |
|---|---|---|
| Munich | 17 January 2008 | Brown, Julian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## EP 2 037 501 A1

ANNEX TO THE EUROPEAN SEARCH REPORT
ON EUROPEAN PATENT APPLICATION NO.

EP 07 11 6428

This annex lists the patent family members relating to the patent documents cited in the above-mentioned European search report.
The members are as contained in the European Patent Office EDP file on
The European Patent Office is in no way liable for these particulars which are merely given for the purpose of information.

17-01-2008

| Patent document cited in search report | | Publication date | Patent family member(s) | | Publication date |
|---|---|---|---|---|---|
| WO 02075891 | A | 26-09-2002 | EP<br>JP | 1368874 A1<br>2004533713 T | 10-12-2003<br>04-11-2004 |
| US 2006262471 | A1 | 23-11-2006 | NONE | | |
| US 6777721 | B1 | 17-08-2004 | US | 7195958 B1 | 27-03-2007 |
| WO 9605641 | A | 22-02-1996 | EP<br>JP<br>US<br>US | 0776539 A1<br>10504421 T<br>5600525 A<br>5615074 A | 04-06-1997<br>28-04-1998<br>04-02-1997<br>25-03-1997 |
| US 2007120193 | A1 | 31-05-2007 | CN | 1976028 A | 06-06-2007 |

EPO FORM P0459

For more details about this annex : see Official Journal of the European Patent Office, No. 12/82

21

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6768616 B

**Non-patent literature cited in the description**

- **MARKUS P.J. MERGENS et al.** Advanced SCR ESD Protection Circuits for CMOS/SOI Nanotechnologies. *IEEE 2005 CUSTOM INTEGRATED CIR-CUITS CONFERENCE,* 2005, 481-488